Europäisches Patentamt

European Patent Office

Office européen des brevets

(19)

(11) Publication number : **0 345 380 B1**

(12)

# EUROPEAN PATENT SPECIFICATION

(45) Date of publication of patent specification :
10.05.95 Bulletin 95/19

(51) Int. Cl.⁶ : **H01L 29/41,** H01L 29/06,
H01L 29/78, H01L 21/28

(21) Application number : 88116864.5

(22) Date of filing : 11.10.88

(54) **Manufacture of a semiconductor device.**

(30) Priority : 08.06.88 JP 141008/88

(43) Date of publication of application :
13.12.89 Bulletin 89/50

(45) Publication of the grant of the patent :
10.05.95 Bulletin 95/19

(84) Designated Contracting States :
CH DE GB LI

(56) References cited :
EP-A- 0 159 663
PATENT ABSTRACTS OF JAPAN, vol. 10, no.
340 (E-455)[2396], 18th November 1986 &
JP-A-61 142 775
IEEE TRANSACTIONS ON ELECTRON DE-
VICES, vol. ED-34, no. 11, November 1987,
pages 2329-2334, IEEE, New York, US; H.-R.
CHANG et al.: "Self-aligned UMOSFET's with
a specific on-resistance of 1 mpi . cm2"

(73) Proprietor : MITSUBISHI DENKI KABUSHIKI
KAISHA
2-3, Marunouchi 2-chome
Chiyoda-ku
Tokyo 100 (JP)

(72) Inventor : Harada, Masana c/o Mitsubishi
Denki K.K.
Eru-Esu-Ai Kenkyusho
1, Mizuhara 4-chome
Itami-shi Hyogo (JP)

(74) Representative : Sajda, Wolf E., Dipl.-Phys. et
al
MEISSNER, BOLTE & PARTNER
Widenmayerstrasse 48
D-80538 München (DE)

## Description

## BACKGROUND OF THE INVENTION

Field of the Invention

The present invention relates to the manufacturing process of a field effect type transistor having a vertical channel, such as a so-called UMOSFET.

Description of the Prior Art

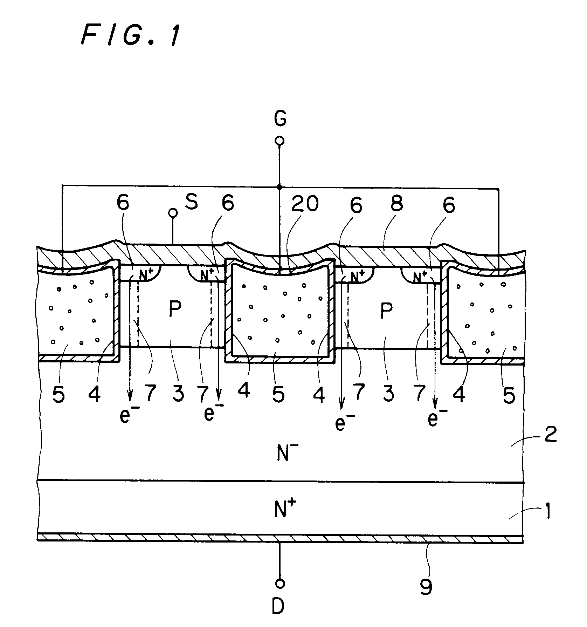

Fig. 1 is a cross-sectional view showing a conventional N channel type UMOSFET described in the document "IEEE TRANSACTIONS ON ELECTRON DEVICES, VOL. ED-34, No. 11, NOVEMBER 1987, P. 2329", for example. Referring to Fig. 1, an $N^-$ type epitaxial layer 2 is formed on an $N^+$ type semiconductor substrate 1. These $N^+$ type semiconductor substrate 1 and $N^-$ type epitaxial layer 2 serve as a drain region. P type well regions 3 are formed on the $N^-$ type epitaxial layer 2. The P type well regions 3 are generally formed by diffusing P type impurities into the $N^-$ type epitaxial layer 2. The P type well regions 3 are provided with U-shaped trenches which are filled up by gate electrodes 5 with gate insulation films 4 interposed. The gate electrodes 5 are formed by polysilicon doped with impurities in high concentration, for example. The surfaces of the gate electrodes 5 are covered with insulation films 20 to form a buried gate structure. $N^+$ type source regions 6 are formed in the surfaces of the P type well regions 3. Portions 7 of the P type well regions 3, which extend between the $N^+$ type source regions 6 and the $N^-$ type epitaxial layer (drain region) 2 along the insulation films 4, are defined as channel regions. A metal source electrode 8 is formed all over the top surface of the shown structure to be electrically connected to the $N^+$ type source regions 6 and the P type well regions 3, while a metal drain electrode 9 is formed all over the back surface of the shown structure to be electrically connected to the $N^+$ type semiconductor substrate (drain region) 1. The gate electrodes 5, the source electrode 8 and the drain electrode 9 are connected to a gate terminal G, a source terminal S and a drain terminal D, respectively.

The operation of this UMOSFET will now be described. A main voltage is applied, so that the drain terminal D is on a high electric potential and the source terminal S is on a low electric potential. When a positive bias is applied to the gate terminal G, inversion layers are formed in the channel regions 7 so that an electronic current flows from the $N^+$ source regions 6 to the $N^-$ epitaxial layer (drain region) 2 through the channel regions 7. Thus, the transistor is turned on. When the positive bias applied to the gate terminal G is removed or a negative bias is applied to the gate terminal G, the inversion layers in the channel regions 7 disappear so that the transistor is turned off.

The UMOSFET, having the channel formed vertically, has the following advantages as compared with a DMOSFET, having the channel formed laterally. First, the surface area of one cell unit of the UMOSFET, including one gate electrode 5 and two $N^+$ type source regions 6 adjacent to the one gate electrode 5 in the figure, becomes smaller than that of the DMOSFET, and hence it becomes possible to enhance integration of cells. Secondly, the UMOSFET has no JFET effect, which is caused between wells in the DMOSFET, as is evident from the structure of the UMOSFET, so that a semiconductor device having an extremely low ON resistance can be implemented.

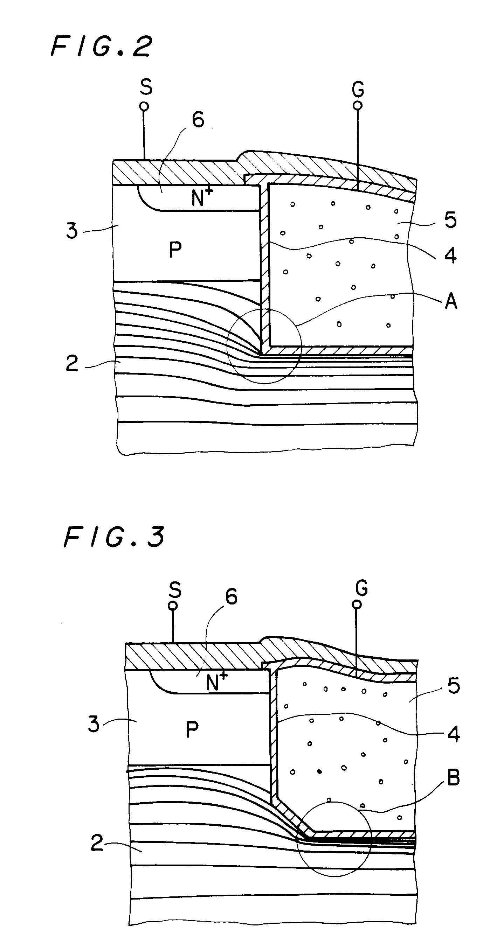

In the conventional UMOSFET structured as hereinbefore described, it is necessary to dig the U shaped trenches which reach the $N^-$ type epitaxial layer 2 through the P type well regions 3, for forming the buried gate structure. The breakdown voltage of the device is mainly determined by the reverse breakdown voltage of a p-n junction formed by the P type well regions 3 and the $N^-$ type epitaxial layer 2. In the OFF state of the device, a depletion layer extends from the P type well regions 3 to the $N^-$ type epitaxial layer 2, to block the main voltage applied across the source and drain terminals S and D. In this case, a strong electric field is caused in the portion of the $N^-$ type epitaxial layer 2 near the sharp corners and bottoms of the trenches, as shown in a circle A in Fig. 2. As a result, the breakdown voltage of the UMOSFET is disadvantageously decreased, although the UMOSFET is able to have a low ON voltage.

To moderate such a high electric field, a method was proposed, in which the bottom corners of a trench are made rounded, as shown in Fig. 3. In this method, however, the gate insulation film 4 is relatively thickly formed to be curved at the corner of the trench, in general, and thereafter the gate insulation film 4 is etched to be in desired thickness. This processing becomes difficult as the trench is made finer, such as $3\mu m$ in width. Further, even by this method, the electric field under the bottom of the trench cannot be moderated, as shown in a circle B in Fig. 3. A further semiconductor device is disclosed in Pat. Abs. Jap. vol. 10 no 340 (E-455)[2396], 18th Nov 1986 and JP-A-61 142 775.

## SUMMARY OF THE INVENTION

A method for manufacturing a semiconductor device according to the present invention comprises the steps of preparing a first conductivity type semiconductor layer on a substrate of first or second conductivity type, forming a second conductivity type floating region in the surface of the semiconductor layer, forming a second conductivity type first semiconductor region on the surface of the semiconductor layer, and forming a trench in the first semiconductor region. The trench reaches said floating region so that the surface of the floating region lies below the surface of the semiconductor layer. The method further comprises the step of forming an insulation film on the surface of the trench, forming a first conductivity type second semiconductor region in a portion of the surface of the first semiconductor region adjacent to the trench. A portion of the first semiconductor region, which extends between the second semiconductor region and the semiconductor layer adjacent to the trench, is defined as a channel region. The method still further comprises the steps of forming a gate electrode layer on the insulation film, forming a first electrode layer on the first and second semiconductor regions, and a second electrode layer on the back surface of the semiconductor layer.

Accordingly, it is an object of the present invention to provide a manufacturing method for a semiconductor device having a vertical channel, which can moderate an electric field so that the breakdown voltage of the semiconductor device is increased.

These and other objects, features, aspects and advantages of the present invention will become more apparent from the following detailed description of the present invention when taken in conjunction with the accompanying drawings.

## BRIEF DESCRIPTION OF THE DRAWINGS

Fig. 1 is a cross-sectional view showing a conventional UMOSFET;

Fig. 2 and Fig. 3 are cross-sectional views showing electric fields in the vicinity of a trench;

Fig. 4 is a cross-sectional view showing a UMOSFET manufactured in accordance with the present invention;

Fig. 5A to Fig. 5H are cross-sectional views showing manufacturing steps for producing the UMOSFET shown in Fig. 4;

Fig. 6 is a cross-sectional view showing the moderation of an electric field in the vicinity of a trench;

Fig. 7A and Fig. 7B are views showing the result of a simulation;

Fig. 8 is a cross-sectional view showing conditions of the simulation;

Fig. 9 is a graph showing the result of the simulation;

Fig. 10 is a cross-sectional view showing the direction of the axis of coordinates of the graph shown in Fig. 9;

Fig. 11 is a cross-sectional view showing a VMOSFET manufactured in accordance with the present invention; and

Fig. 12A and Fig. 12B are cross-sectional views showing manufacturing steps for producing the VMOSFET shown in Fig. 11.

## DETAILED DESCRIPTION OF THE PREFERRED EMBODIMENTS

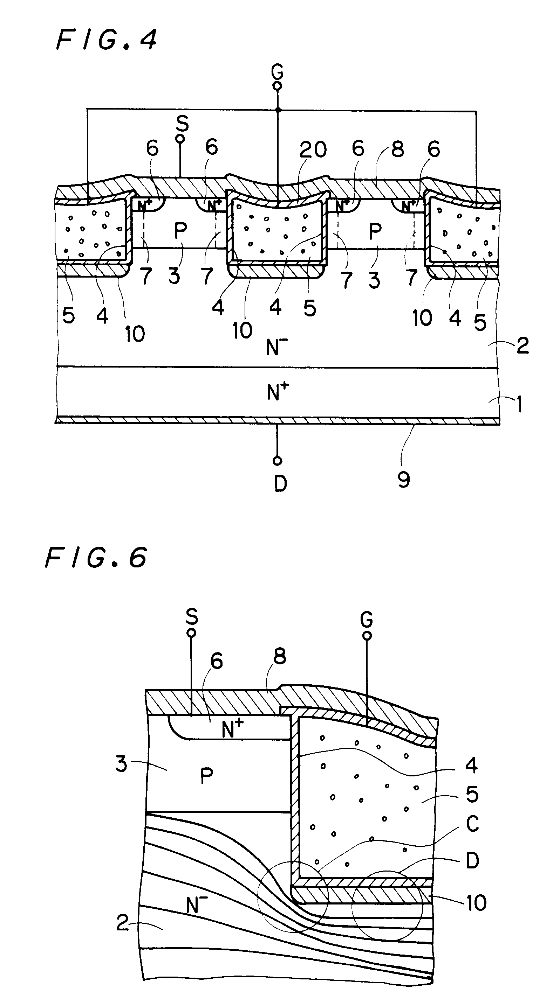

Fig. 4 is a cross-sectional view showing an N channel type UMOSFET manufactured in accordance with the present invention. Referring to Fig. 4, impurity diffusion layers (hereinafter referred to as floating well regions) 10 of the same conductivity type (i.e., P type) as the well regions 3 are provided just under trenches in which gate electrodes 5 are filled up-,which is different from the conventional N channel type UMOSFET shown in Fig. 1. Other structures are the same as in the conventional N channel type UMOSFET shown in Fig. 1.

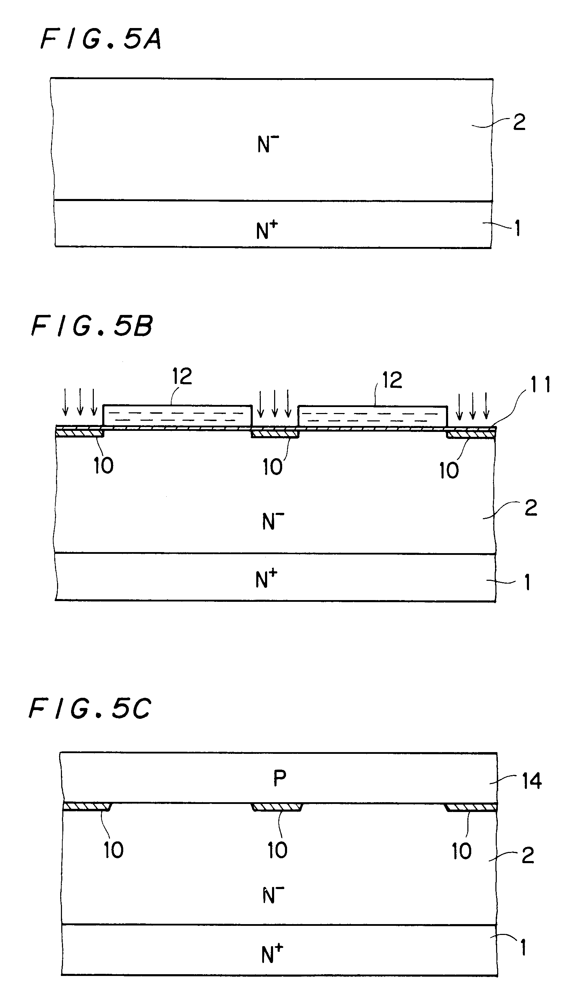

The manufacturing process of the N channel type UMOSFET shown in Fig. 4 will now be described with reference to Fig.5A to 5H.First, an $N^-$ type epitaxial layer 2 is epitaxially grown on an $N^+$ type semiconductor substrate 1, as shown in Fig. 5A. These $N^+$ type semiconductor substrate 1 and $N^-$ type epitaxial layer 2 serve as a drain region. Then, an oxide film 11 is formed on the surface of the $N^-$ type epitaxial layer 2, thereafter resist portions 12 patterned in a predetermined configuration are formed on the oxide film 11, as shown in Fig. 5B. Then, P type impurity ions are selectively implanted into the $N^-$ type epitaxial layer 2 as shown by arrows by using the resist portions 12 as a mask, and thereafter the implanted ions are diffused through heat treatment to form the floating well regions 10.

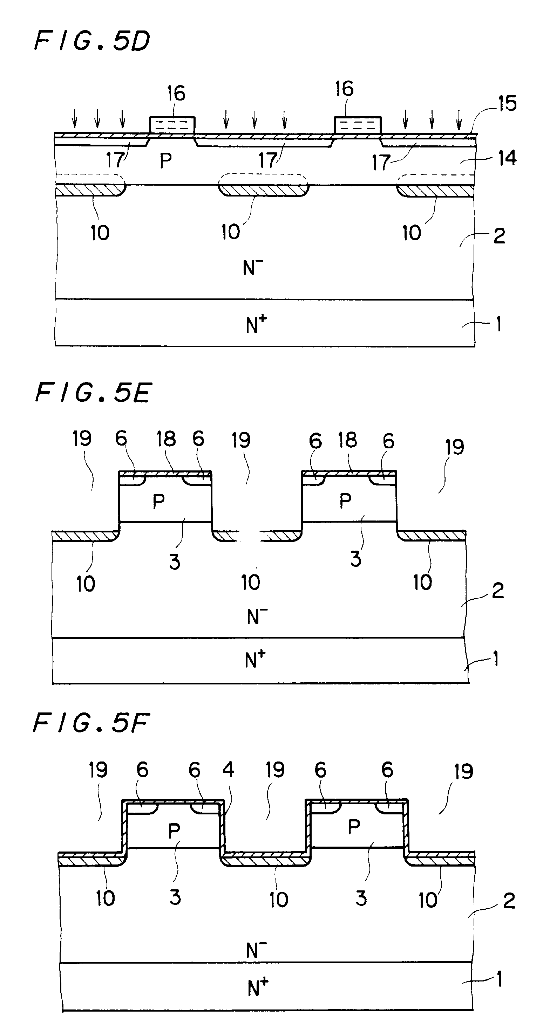

Then, the oxide film 11 and the resist portions 12 are removed, and a P type epitaxial layer 14 is epitaxially grown on the $N^-$ type epitaxial layer 2, as shown in Fig. 5C. Then, an oxide film 15 is formed on the surface of the P type epitaxial layer 14, and thereafter resist portions 16 patterned in a predetermined configuration are formed on the oxide film 15, as shown in Fig. 5D. Then, N type impurity ions are selectively implanted into the P type epitaxial layer 14 as shown by arrows by using the resist portions 16 as a mask, and thereafter the implanted ions are diffused by heat treatment to form $N^+$ type regions 17. Through this heat treatment, some P type impurity ions in the floating well regions 10 are diffused into the P type epitaxial layer 14, as shown by dotted lines.

Then, as shown in Fig. 5E, the oxide film 15 and the resist portions 16 are removed, and another oxide film 18, which is larger in thickness than the oxide film 15, is formed on the surface of the P type epitaxial 14 and patterned to open windows just above the floating well regions 10. Anisotropic etching processing is performed by using the patterned oxide film 18 as a mask, to dig U shaped trenches 19 which reach the floating well regions 10. Remaining portions of the epitaxial layer 14 after the etching processing are defined as P type well regions 3, and remaining portions of the $N^+$ type regions 17 are defined as $N^+$ type source regions 6. The bottoms of the trenches 19 enter the N⁻ type epitaxial layer 2 several μm away from interfaces of the N⁻ type epitaxial layer 2 and the P type well regions 3. As a result, the P type floating well regions 10 and the P type well regions 3 are separated from each other. Each floating well region 10 covers all over the bottom surface of the corresponding trench 19, and the thickness thereof is so selected that any JFET effect is not caused between the adjacent P type floating well regions 10.

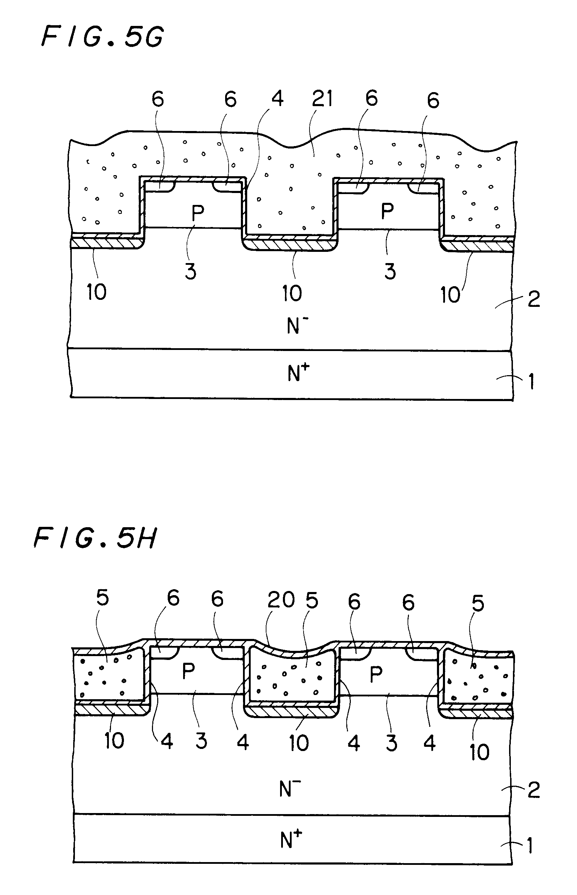

Then, the oxide film 18 is removed, and a gate insulation film 4 is formed through a thermal oxidation processing, as shown in Fig. 5F. Thereafter, the trenches 19 are buried by depositing a polysilicon layer 21 doped with impurities, for example, by a CVD method and the like, as shown in Fig. 5G. Then, the top surface is flattened through a flattening technique such as an etchback method, to leave only portions of the polysilicon layer 21 in the trenches, as shown in Fig. 5H. These remaining portions of the polysilicon layer 21 are defined as gate electrodes 5. Then, all the top surface is covered with an insulation film 20 through a terminal oxidation processing. Thereafter, portions of the insulation film 20 on the P type well regions 3 are removed to provide contact holes, and a metallization processing is performed to form a source electrode 8 on a top surface and a drain electrode 9 on a back surface. Thus, the USMOSFET of the structure shown in Fig. 4 is implemented.

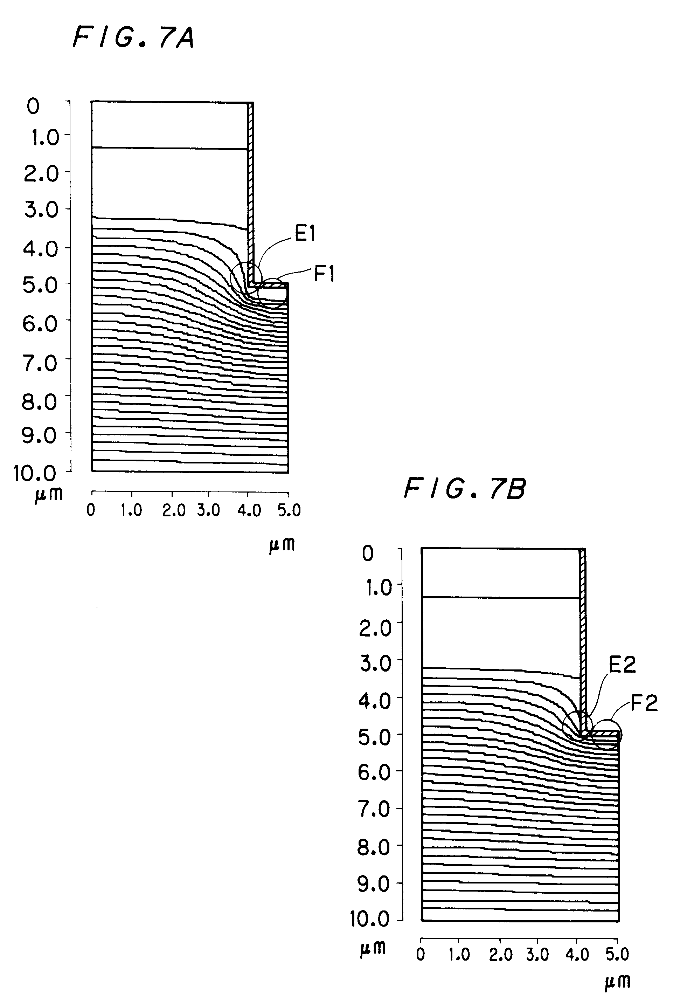

The floating well regions 10 are similar in operation to a field limiting ring used for planar type high breakdown voltage devices. When, in an OFF state, a depletion layer extends from the P type well regions 3 into the N⁻ type epitaxial layer 2 over the floating well regions 10, an electric field at the edge and bottom portions of the floating well regions 10 is moderated by virtue of the operation of depletion layers extending from the floating well regions 10 into the N⁻ type epitaxial layer 2, as shown in circles C and D in Fig. 6. Thus,the field strength is weakened. As a result, the breakdown voltage of the UMOSFET is increased.

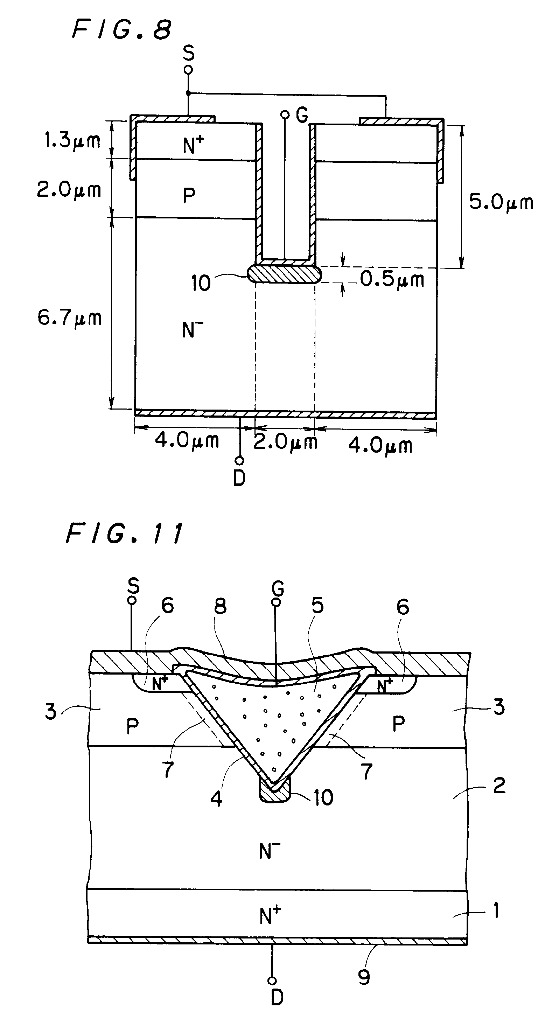

Fig. 7 is a cross-sectional view showing the result of a simulation of a field distribution, where Fig. 7A shows an effect under the condition that a floating well region 10 is provided and Fig. 7B shows an effect under the condition that no floating well region 10 is provided. This simulation is performed on the basis of a structure shown in Fig. 8. Gate and source terminals G and S are grounded and a voltage of 30 V is applied to a drain terminal D. As is evident from comparing portions in circles E1 and F1 in Fig. 7A with those in circles E2 and F2 in Fig. 7B, the electric field is moderated in the N⁻ type layer near the corner and bottom portions of the trench, by virtue of the operation of the floating well region 10.

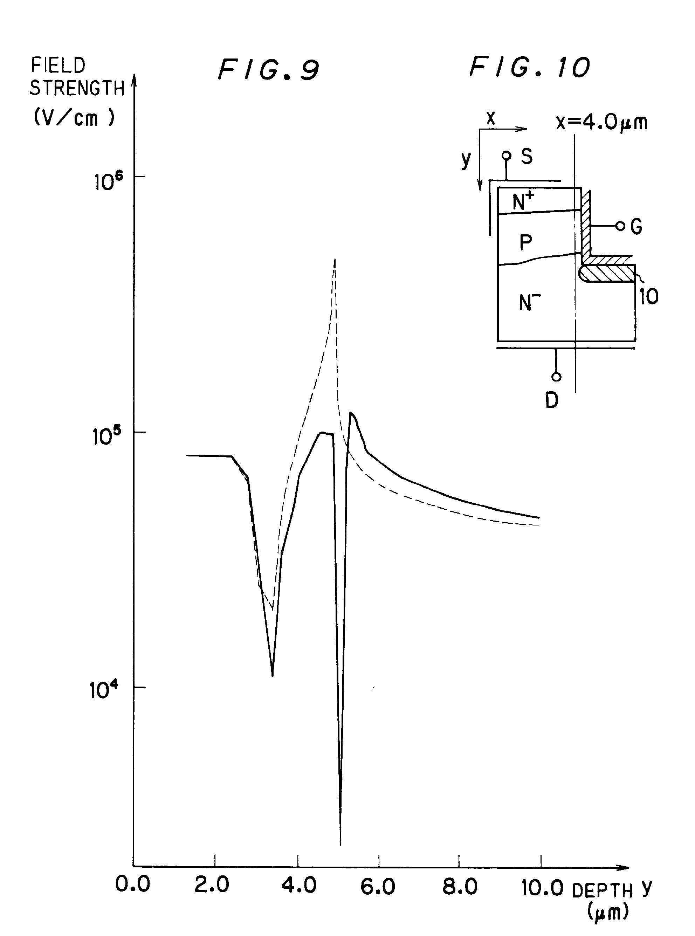

Fig. 9 is a graph showing the result of this simulation along a y-direction (i.e., direction of the depth) at a position of x = 4,0 μm in Fig. 10. In Fig. 9, solid and dotted lines denote field strengthes (V/cm) in devices having the floating well region 10 and no floating well region 10, respectively. Remarkable difference appears in the vicinity of y = 5,0 μm. Thus, it is clear that the field strength is weakened at the edge of the floating well region 10, by virtue of the operation of the floating well region 10.

In the manufacturing method illustrated in Fig.5A to 5H, the P type well region 3, which was conventionally formed by diffusion from the top surface, is formed by an epitaxial growth method. This enhances controllability of the thickness and the impurity concentration of the P type well region 3, i.e., the channel length and the impurity concentration of the channel region. In a low ON resistance UMOSFET, the channel resistance is a main factor in determining the ON voltage of the UMOSFET. In general, the channel resistance $R_{CH}$ of a MOS structure is

$$R_{CH} = (L/W) \{1/(\mu_n \times \varepsilon_{si})\} \{T_{ox}/(V_G - V_{th})\}$$

where, L is a gate channel length, W is a channel width, $\mu_n$ is a surface electron mobility, $\varepsilon_{si}$ is the dielectric constant of silicon, $T_{ox}$ is the thickness of a gate insulation film, $V_G$ is a gate bias voltage and $V_{th}$ is a gate threshold voltage. As is evident from the above equation, the channel resistance $R_{CH}$ is in proportion to the gate channel length L and influenced by the impurity concentration of the channel region through the electron mobility $\mu_n$. Therefore, it becomes easy to design a device for decreasing the ON voltage of the device by forming the P type well region 3 by using the epitaxial growth method, since the controllability of the channel length and the impurity concentration of the channel region are increased as hereinbefore described.

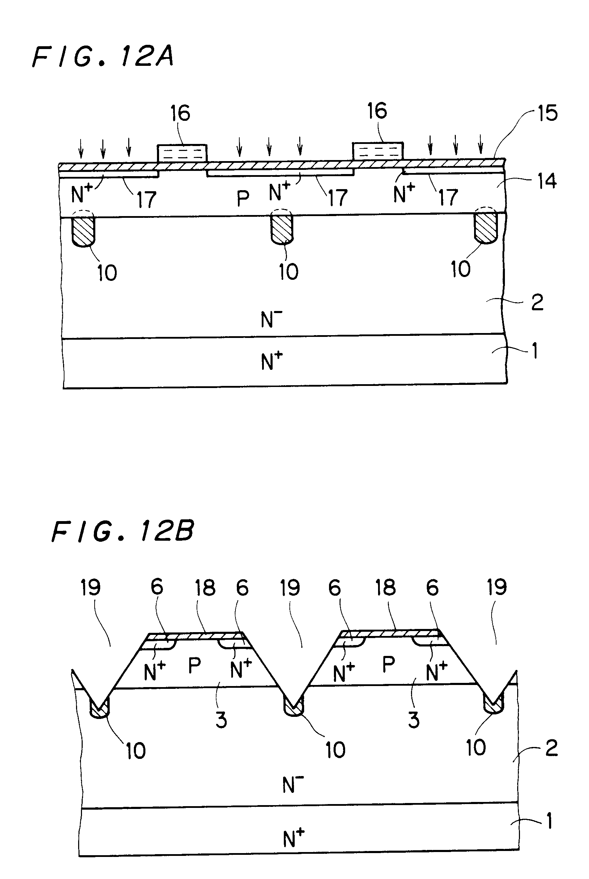

Fig. 11 is a cross-sectional view showing an N channel type VMOSFET manufactured in accordance with the present invention. This VMOSFET differs from the UMOSFET shown in Fig. 4 in that a gate electrode 5 is buried in a V shaped trench rather than a U shaped trench, and a floating well region 10 is formed around the bottom edge of the V shaped trench. The VMOSFET is a sort of a vertical channel structure type MOSFET, and the channel region 7 thereof is defined obliquely along side surfaces of the V shaped trench. Also, in this VMOSFET, the breakdown voltage thereof can be increased by providing the floating well region 10, similarly to the UMOSFET as hereinbefore described.

Fig. 12 is a cross-sectional view showing the manufacturing process of the VMOSFET shown in Fig. 11, where the step of Fig. 12A corresponds to the step of Fig. 5D of the hereinbefore described UMOSFET, and the step of Fig. 12B corresponds to the step of Fig. 5E. In Fig. 12A, each floating well region 10 is formed in a relatively narrow area. In Fig. 12B, each trench is formed to be in a V shape through an isotropic etching processing. Other manufacturing steps are the same as those of the UMOSFET illustrated in Fig. 5A to 5C and 5F to 5H.

Although an N channel type MOSFET's manufacturing process having a vertical channel structure has been described, the present invention is applicable to a P channel type MOSFET manufacturing process having a vertical channel structure, as a matter of course. Further, there is the possibility that the vertical channel structure is employed in other transistor manufacturing processes such as an insulated gate bipolar transistor which is a field effect type transistor having a MOS structure, to increase integration of cells, and in this case, the floating well structure is applicable in accordance with the manufacturing process of present invention. In the case of an insulated gate bipolar transistor, a P type semiconductor substrate is employed instead of the $N^+$ type semiconductor substrate 1 in Fig. 4.

## Claims

1. A method of manufacturing a semiconductor device, comprising the steps in the following order:
   - preparing a first conductivity type semiconductor layer (2) on a substrate (1) of a first or second conductivity type thereby forming first and second major surfaces;
   - forming a second conductivity type floating region (10) in the semiconductor layer (2), said floating region (10) having a top surface coincident with the first major surface of said semiconductor layer (2) and a thickness reaching a predetermined depth of the semiconductor layer;
   - forming a second conductivity type first semiconductor region (14, 3) on the first major surface of the semiconductor layer (2) including the top surface of the floating region (10);
   - forming a first conductivity type second semiconductor region (17, 6) in a portion of the surface of the first semiconductor region (14, 3) including and wider than a a location provided for the formation of a trench (19);
   - forming a trench (19) in the first semiconductor region (14,) and the second semiconductor region (17), wherein the trench (19) reaches the floating region (10), so that the top surface of the floating region (10) is removed and a new top surface of the floating region (10) is formed which is below the first major surface of the semiconductor layer (2);
   - forming an insulation film (4) on the surface of the trench (19);
   - wherein a portion (7) of the first semiconductor region (3), which extends between the second semiconductor region (6) and the semiconductor layer (2) adjacent to the trench (19), is defined as a channel region;
   - forming a gate electrode layer (5) on the insulation film (4);
   - forming a first electrode layer (8) on the first and second semiconductor regions (3, 6) and a second electrode layer (9) on the second major surface.

2. The method according to claim 1, wherein the step of forming a first semiconductor region (14, 3) includes the step of epitaxially growing the first semiconductor region.

## Patentansprüche

1. Verfahren zur Herstellung einer Halbleitervorrichtung, das in Reihe die folgenden Schritte aufweist:
   - Herstellen einer Halbleiterschicht (2) von einem ersten Leitfähigkeitstyp auf einem Substrat (1) von einem ersten oder zweiten Leitfähigkeitstyp, um dadurch eine erste und zweite Hauptfläche zu bilden;
   - Ausbilden eines Floating-Bereichs (10) von einem zweiten Leitfähigkeitstyp in der Halbleiterschicht (2), wobei der Floating-Bereich (10) eine Oberfläche an der Oberseite, die mit der ersten Hauptfläche der Halbleiterschicht (2) zusammenfällt, sowie eine Dicke aufweist, die eine vorbestimmte Tiefe der Halbleiterschicht erreicht;
   - Ausbilden eines ersten Halbleiterbereichs (14, 3) von einem zweiten Leitfähigkeitstyp auf der ersten Hauptfläche der Halbleiterschicht (2) einschließlich der Oberfläche an der Oberseite des Floating-Bereichs (10);
   - Ausbilden eines zweiten Halbleiterbereichs (17, 6) von einem ersten Leitfähigkeitstyp in einem Bereich der Fläche des ersten Halbleiterbereichs (14, 3), der eine für die Bildung eines Grabens (19) vorgesehene Stelle enthält und breiter als diese ist;
   - Ausbilden eines Grabens (19) in dem ersten Halbleiterbereich (14) und dem zweiten Halbleiterbereich (17), wobei der Graben (19) den Floating-Bereich (10) erreicht, so daß die Oberfläche an der Oberseite des Floating-Bereichs (10) entfernt und eine neue Oberfläche an der Oberseite des Floating-Bereichs (10) gebildet ist, die unter der ersten Hauptfläche der Halbleiterschicht (2) liegt;
   - Ausbilden einer Isolierschicht (4) auf der Oberfläche des Grabens (19);
   - wobei ein Bereich (7) des ersten Halbleiterbereichs (3), der sich zwischen dem zweiten Halbleiterbereich (6) und der an den Graben (19) angrenzenden Halbleiterschicht (2) befindet, als Kanalbereich gebildet wird;

- Ausbilden einer Gate-Elektrodenschicht (5) auf der Isolierschicht (4);
- Ausbilden einer ersten Elektrodenschicht (8) auf dem ersten und dem zweiten Halbleiterbereich (3, 6) sowie einer zweiten Elektrodenschicht (9) auf der zweiten Hauptfläche.

2. Verfahren nach Anspruch 1, wobei der Schritt des Ausbildens eines ersten Halbleiterbereichs (14, 3) den Schritt des epitaxialen Aufwachsens des ersten Halbleiterbereichs umfaßt.

**Revendications**

1. Procédé de fabrication d'un dispositif semiconducteur, comprenant dans l'ordre suivant les étapes consistant à:
   - préparer une couche semi-conductrice (2) d'un premier type de conductivité sur un substrat (1) d'un premier ou d'un second type de conductivité, formant ainsi une première et une seconde surface principales;
   - former une région flottante (10) d'un second type de conductivité dans la couche semi-conductrice (2), ladite région flottante (10) possédant une surface supérieure qui coïncide avec la première surface principale de ladite couche semi-conductrice (2), et une épaisseur qui atteint une profondeur prédéterminée de la couche semi-conductrice;
   - former une première région semi-conductrice (14, 3) d'un second type de conductivité sur la première surface principale de la couche semi-conductrice, incluant la surface supérieure de la région flottante (10) ;
   - former une seconde région semi-conductrice (17, 6) d'un premier type de conductivité dans une partie de la surface de la première région semi-conductrice (14, 3), incluant un emplacement prévu pour la formation d'une tranchée (19), et plus large que cet emplacement;
   - former une tranchée (19) dans la première région semiconductrice (14, 3) et dans la seconde région semi-conductrice (17), ladite tranchée (19) atteignant la région flottante (10) de sorte que la surface supérieure de la région flottante (10) est enlevée et une nouvelle surface supérieure de la région flottante (10) est formée, qui se trouve au-dessous de la première surface principale de la couche semi-conductrice (2);
   - former un film isolant (4) sur la surface de la tranchée (19);
   - dans lequel une partie (7) de la première région semiconductrice (3) qui s'étend entre la seconde région semi-conductrice (6) et la couche semi-conductrice (2) adjacente à la tranchée (19), est définie comme région formant un canal;
   - former une couche d'électrode de grille (5) sur le film isolant (4);
   - former une première couche électrode (8) sur la première et la seconde région semiconductrice (3, 6) et une seconde couche électrode (9) sur la seconde surface principale.

2. Procédé selon la revendication 1, dans lequel l'étape consistant à former une première région semi-conductrice (14, 3) comprend l'étape consistant à faire croître la première région semi-conductrice par voie épitaxiale.

FIG. 1

FIG.2

FIG.3

# FIG.4

# FIG.6

*F I G . 5 A*

N⁻ ⟶ 2

N⁺ ⟶ 1

*F I G . 5 B*

12          12          11

10          10          10

N⁻ ⟶ 2

N⁺ ⟶ 1

*F I G . 5 C*

P ⟶ 14

10          10          10 ⟶ 2

N⁻

N⁺ ⟶ 1

FIG.5D

16   16   15
17   P   17   17   14
10   10   10   2
N⁻
N⁺   1

FIG.5E

19   6   18   6   19   6   18   6   19
P   P
10   3   10   3   10   2
N⁻
N⁺   1

FIG.5F

19   6   6   4   19   6   6   19
P   P
10   3   10   3   10   2
N⁻
N⁺   1

11

## FIG.5G

## FIG.5H

FIG. 7A

FIG. 7B

FIG.8

S

G

1.3μm    N⁺

2.0μm    P

6.7μm    N⁻

10        0.5μm

5.0μm

4.0μm    2.0μm    4.0μm

D

FIG. 11

S    6    8    G    5    6

N⁺        N⁺

3    P    7    7    P    3

4    10    2

N⁻

N⁺    1

9

D

14

FIELD STRENGTH (V/cm)

*FIG.9*

*FIG.10*

## FIG.12A

## FIG.12B